# EUROPEAN PATENT SPECIFICATION

(11) **EP 4 549 975 B1**
(45) Date of publication and mention of the grant of the patent: **09.12.2026**
(21) Application number: 23868624.0
(22) Date of filing: 21.09.2023
(51) Int. Cl.: G01R 31/396, G01R 31/371, G01R 31/36

(54) **BATTERY INFORMATION COMMUNICATION SYSTEM AND METHOD**
BATTERIEINFORMATIONSKOMMUNIKATIONSSYSTEM UND -VERFAHREN
SYSTÈME ET PROCÉDÉ DE COMMUNICATION D'INFORMATIONS DE BATTERIE

(30) Priority: 22.09.2022 KR 20220120139
(43) Date of publication of application: 07.05.2025
(73) Proprietor: LG Energy Solution, Ltd., Seoul 07335 (KR)
(72) Inventor: JEONG, Jong-Mun, Daejeon 34122 (KR)
(74) Representative: Plasseraud IP
(86) International application number: PCT/KR2023/014423
(87) International publication number: WO 2024/063572

(56) References cited:
- KR-A- 20060 047 189
- KR-A- 20160 061 092
- KR-A- 20190 000 992
- KR-A- 20190 000 992
- KR-A- 20200 042 426
- KR-A- 20200 042 426
- KR-A- 20210 046 407
- US-A1- 2005 237 024

## Description

### TECHNICAL FIELD

The present disclosure relates to a battery information communication system and method, and more specifically, to a battery information communication system and method that may effectively transmit and receive information about a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Battery information related to this battery may include various information such as terminal voltage, OCV (Open circuit voltage), current, SOC (State of charge), SOH (State of health), and resistance. Since this battery information is measured and/or estimated at regular intervals, the amount of battery information over a certain period of time may be enormous. Moreover, in the case of an electric vehicle or ESS (Energy storage system) that includes multiple batteries, the amount of data that needs to be transmitted (total amount of battery information) may be enormous.

For example, assume that the RBMS (Rack battery management system) of the ESS transmits SOC information of each of the plurality of battery modules included in the battery rack to the BBMS (Bank battery management system). In addition, the explanation assumes that the charging of the battery module is determined based on the SOC information received by the BBMS. Here, note that RBMS corresponds to a lower controller, and BBMS corresponds to an upper controller.

Conventionally, in order to transmit each SOC information in 1 byte, a method of transmitting the SOC information by adjusting the scale to 0.5 has been used. For example, values less than 0.5% with the decimal point are rounded down, and values more than or equal to 0.5% with the decimal point are rounded up to convert the SOC information into an integer, and then the converted value is transmitted. In this case, there is a problem that the maximum error of SOC information can be 0.5%.

For example, when the power limit is adjusted according to the SOC value during charging, if the SOC is 50% or higher, the power limit is actually reduced at a SOC value lower than the standard SOC, so there arises a problem that the power limit is adjusted to 0 before reaching the standard SOC at the charging end. That is, charging may end before reaching the charging termination SOC. This is because the scale is 0.25, so the SOC value obtained by the receiving side (e.g., BBMS) may be larger than the actual SOC value estimated by the transmitting side (e.g., RBMS). In other words, because the power limit is adjusted to 0 sooner than it actually is, there is a problem that less capacity than the actual capacity of the battery may be used.

In addition, when the battery is discharged, the power limit is adjusted according to the SOC, but even in this case, there is a problem that less capacity than the actual capacity of the battery may be used. That is, the discharge may end before reaching the discharge end SOC. This is because the scale is 0.25, so the SOC value obtained by the receiving side (e.g., BBMS) may be smaller than the actual SOC value estimated by the transmitting side (e.g., RBMS). The documents US 2005/237024 A1, KR 2019 0000992 A, KR 2020 0045426 A are known, but fail to overcome the aforementioned issue.

### DISCLOSURE

### Technical Problem

The present disclosure is designed to solve the problems of the related art, and therefore the present disclosure is directed to providing a battery information communication system and method that may prevent the loss of the available capacity of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery information communication system according to one aspect of the present disclosure may comprise a battery information transmission device configured to obtain first battery information related to a battery, generate conversion information by applying a preset conversion rule to the first battery information to correspond to a charging and discharging state of the battery, and transmit the conversion information; and a battery information receiving device configured to receive the conversion information from the battery information transmission device, and reconvert the conversion information to correspond to the conversion rule to obtain second battery information corresponding to the first battery information.

The battery information transmission device may be configured to generate the conversion information by applying a preset first conversion rule when the battery is in a charging state.

The battery information transmission device may be configured to generate the conversion information by applying a preset second conversion rule when the battery is in a discharging state.

The battery information transmission device may be configured to generate the conversion information by converting a weight value of the battery information by rounding down below a decimal point, based on the first conversion rule.

The battery information transmission device may be configured to generate the conversion information according to the first conversion rule based on Formula 1 below. [Formula 1] $C = \left⌊K\times n\right⌋$

Here, C may be the conversion information, K may be the first battery information, and n may be a predetermined conversion factor.

The battery information transmission device may be configured to generate the conversion information by converting a weight value of the battery information by rounding up below a decimal point, based on the second conversion rule.

The battery information transmission device may be configured to generate the conversion information according to the second conversion rule based on Formula 2 below. [Formula 2] $C = \left⌈K\times n\right⌉$

Here, C may be the conversion information, K may be the first battery information, and n may be a predetermined conversion factor.

The battery information transmission device may be configured to set the conversion information to a preset discharge end value when the first battery information is less than a preset threshold value, based on the second conversion rule.

The battery information receiving device may be configured to obtain the second battery information with a value less than or equal to the first battery information when the battery is in a charging state.

The battery information receiving device may be configured to obtain the second battery information with a value greater than or equal to the first battery information when the battery is in a discharging state.

The battery information receiving device may be configured to obtain, as the second battery information, a value obtained by dividing the conversion information by a conversion factor multiplied by the first battery information according to the conversion rule.

The battery information receiving device may be configured to control charging and discharging of the battery based on the second battery information.

An ESS (Energy storage system) according to another aspect of the present disclosure may comprise the battery information communication system according to one aspect of the present disclosure.

A battery information communication method according to still another aspect of the present disclosure may comprise a first battery information obtaining step of obtaining first battery information related to a battery by a battery information transmission device; a conversion information generating step of generating conversion information by applying a preset conversion rule to the first battery information to correspond to a charging and discharging state of the battery by the battery information transmission device; and a second battery information obtaining step of reconverting the conversion information to correspond to the conversion rule to obtain second battery information corresponding to the first battery information by a battery information receiving device.

### Advantageous Effects

According to one aspect of the present disclosure, since battery information that is the standard for charging and discharging control is determined to correspond to the state (charging state or discharging state) of the battery, loss of available capacity of the battery may be prevented. In other words, the battery information communication system according to an embodiment of the present disclosure has the advantage of effectively preventing the loss of available capacity of the battery due to inevitable data conversion during the communication process.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery information communication system according to an embodiment of the present disclosure.
FIG. 2 is a diagram schematically showing the operating configuration of the battery information communication system according to an embodiment of the present disclosure.
FIG. 3 is a diagram showing a comparative example of the conventional battery information conversion process.
FIGS. 4 and 5 are diagrams showing an embodiment of a battery information conversion process according to an embodiment of the present disclosure.
FIG. 6 is a diagram schematically showing a battery information conversion method according to another embodiment of the present disclosure.
FIG. 7 is a diagram more specifically showing a conversion information generation step in the battery information conversion method according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

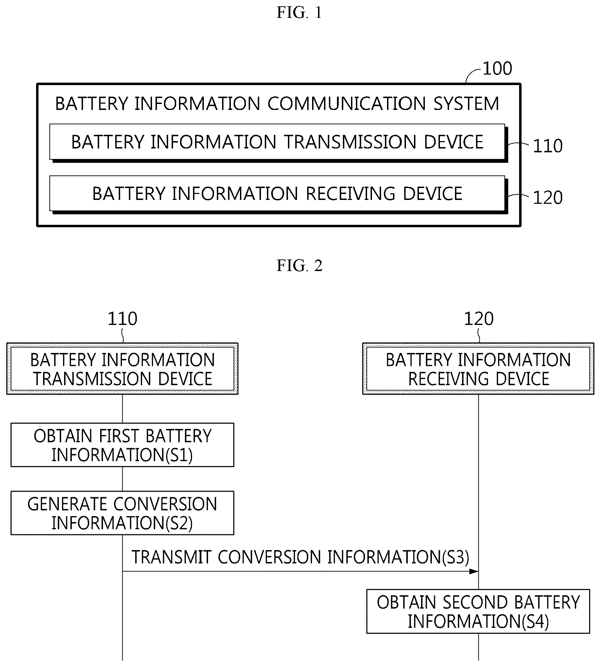

FIG. 1 is a diagram schematically showing a battery information communication system 100 according to an embodiment of the present disclosure.

Referring to FIG. 1, the battery information communication system 100 according to an embodiment of the present disclosure may include a battery information transmission device 110 and a battery information receiving device 120.

Here, the battery refers to an independent cell that has a negative electrode terminal and a positive electrode terminal and is physically separable. As an example, a lithium-ion battery or a lithium polymer battery may be considered a battery. Additionally, the battery may mean a battery module and/or a battery pack in which a plurality of cells are included.

Hereinafter, the battery information communication system 100 will be described with reference to FIG. 2.

FIG. 2 is a diagram schematically showing the operating configuration of the battery information communication system 100 according to an embodiment of the present disclosure.

The battery information transmission device 110 may be configured to obtain first battery information related to the battery.

Specifically, the battery information may include information that may be measured directly from the battery and information that may be estimated from the measured information. Preferably, the information related to the battery may be information that may be used to determine the end point of charging and discharging of the battery. For example, the battery information may be compared with a preset charging and discharging termination condition, and charging and discharging of the battery may be terminated. In one embodiment, the battery information may include voltage, current, temperature, resistance, and state of charge (SOC). However, for convenience of explanation, hereinafter, an embodiment in which the battery information transmission device 110 transmits the SOC of the battery to the battery information receiving device 120 will be described.

For example, the battery information transmission device 110 may obtain the battery information by measuring voltage, current, and temperature of the battery. As another example, the battery information transmission device 110 may receive the battery information from another device that measures voltage, current, and temperature of the battery.

In step S1 of the embodiment of FIG. 2, the battery information transmission device 110 may obtain first battery information.

The battery information transmission device 110 may be configured to generate conversion information by applying a preset conversion rule to correspond to the charging and discharging state of the battery to the first battery information.

Specifically, the conversion rule may be set in advance to correspond to the charging and discharging state of the battery. That is, the conversion rule when the state of the battery is a charging state and the conversion rule when the state of the battery is a discharging state may be different.

For example, when the battery is in a charging state, the battery information transmission device 110 may be configured to generate conversion information by applying a preset first conversion rule. Conversely, when the battery is in a discharging state, the battery information transmission device 110 may be configured to generate conversion information by applying a preset second conversion rule. Here, the first conversion rule and the second conversion rule may be different from each other. That is, because the battery information transmission device 110 generates conversion information according to the conversion rule corresponding to the charging and discharging state of the battery, the second battery information that is finally obtained by the battery information receiving device 120 may vary depending on the charging and discharging state of the battery.

In step S2 of the embodiment of FIG. 2, the battery information transmission device 110 may generate conversion information based on the first battery information and the charging and discharging state of the battery.

The battery information transmission device 110 may be configured to transmit the conversion information. Also, the battery information receiving device 120 may be configured to receive the conversion information from the battery information transmission device 110.

For example, the conversion information may be data with a size of 1 Byte.

Specifically, the battery information transmitting device 110 may be connected to the battery information receiving device 120 to enable communication. For example, the battery information transmitting device 110 may be connected to communicate with the battery information receiving device 120 through wired communication and/or wireless communication. As a specific example, the battery information transmission device 110 may be connected to the battery information receiving device 120 through CAN (Controller area network) communication. Note that the communication protocol between the battery information transmitting device 110 and the battery information receiving device 120 has no special restrictions.

In step S3 of the embodiment of FIG. 2, the battery information transmission device 110 may transmit the conversion information to the battery information receiving device 120.

The battery information receiving device 120 may be configured to reconvert the conversion information to correspond to a conversion rule to obtain second battery information corresponding to the first battery information.

Specifically, the conversion information may be information generated according to a conversion rule from the first battery information. Accordingly, the battery information receiving device 120 may reconvert the conversion information to obtain second battery information corresponding to the first battery information.

In step S4 of the embodiment of FIG. 2, the battery information receiving device 120 may obtain second battery information from the conversion information.

Also, the second battery information may be used as information indicating the state of the battery. For example, the battery information receiving device 120 may be configured to control charging and discharging of the battery based on the second battery information. Specifically, the battery information receiving device 120 may terminate the charging of the battery by comparing the charging termination condition of the battery with the second battery information, and terminate discharging of the battery by comparing the discharging termination condition of the battery with the second battery information.

Preferably, when the battery is in a charging state, the battery information receiving device 120 may be configured to obtain second battery information having a value less than or equal to the first battery information. Conversely, when the battery is in a discharging state, the battery information receiving device 120 may be configured to obtain second battery information having a value greater than or equal to the first battery information. Here, the information indicating the actual state of the battery is the first battery information, and the information obtained by the battery information receiving device 120 is the second battery information.

For example, it is assumed that the first battery information and the second battery information are information about SOC, and the second battery information is equal to or greater than the first battery information. The battery information receiving device 120 may terminate charging of the battery when the second battery information reaches the charging termination SOC. In this case, the actual SOC (corresponding to the first battery information) of the battery has not reached the charging termination SOC, but the charging of the battery may be terminated. In other words, since charging is terminated (power limit is reduced to 0) in a state where the battery charging is not actually completed, the available capacity of the battery may be reduced. Accordingly, when the battery is in a charging state, the battery information receiving device 120 may be configured to obtain second battery information having a value less than or equal to the first battery information.

As another example, it is assumed that the first battery information and the second battery information are information about SOC, and the second battery information is equal to or smaller than first battery information. The battery information receiving device 120 may terminate discharging of the battery when the second battery information reaches the discharging termination SOC. In this case, the actual SOC (corresponding to the first battery information) of the battery has not reached the discharge end SOC, but the discharging of the battery may be terminated. In other words, because the discharging ends (the power limit is reduced to 0) in a state where the battery discharge is not actually completed, the available capacity of the battery may be reduced. Accordingly, when the battery is in a discharging state, the battery information receiving device 120 may be configured to obtain second battery information having a value greater than or equal to the first battery information.

In this way, the battery information communication system 100 has the advantage of being able to obtain the second battery information that is the standard for charging and discharging control based on the state (charging state or discharging state) of the battery so that the available capacity of the battery is not lost.

Below, the conversion rule according to battery state is explained in detail.

The battery information transmission device 110 may be configured to generate conversion information by converting the weight value of the battery information by rounding down below the decimal point, based on the first conversion rule. Specifically, when the state of the battery is a charging state, the battery information transmission device 110 may convert the first battery information into the conversion information according to the first conversion rule.

For example, the battery information transmission device 110 may be configured to generate conversion information according to the first conversion rule based on Formula 1 below. [Formula 1] $C = \left⌊K\times n\right⌋$

Here, C is the conversion information, K is the first battery information, and n may be a predetermined conversion factor. In other words, the conversion information (C) may be the floor function value of the product of the first battery information (K) and the conversion factor (n).

For example, the conversion factor may be a natural number. Preferably, the conversion factor may be a natural number of 2 or more. More preferably, the conversion factor may be 2.

Referring to Formula 1, the part below the decimal point in the value obtained by multiplying the first battery information (K) and the conversion factor (n) may be rounded down. Therefore, the conversion information (C) may always be less than or equal to the value obtained by multiplying the first battery information (K) by the conversion factor (n). For example, if the first battery information (K) is 20.2 and the conversion factor (n) is 2, the conversion information (C) may be 40.

Next, the battery information transmission device 110 may be configured to generate conversion information by converting the weight value of the battery information by rounding up below the decimal point, based on the second conversion rule. Specifically, the battery information transmission device 110 may convert the first battery information into the conversion information according to the second conversion rule when the state of the battery is a discharging state.

The battery information transmission device 110 may be configured to generate conversion information according to the second conversion rule based on Formula 2 below. [Formula 2] $C = \left⌈K\times n\right⌉$

Here, C is the conversion information, K is the first battery information, and n may be a predetermined conversion factor. In other words, the conversion information (C) may be the ceiling function value of the product of the first battery information (K) and the conversion factor (n).

For example, the conversion factor may be a natural number. Preferably, the conversion factor may be a natural number of 2 or more. More preferably, the conversion factor may be 2.

Referring to Formula 2, the part below the decimal point in the value obtained by multiplying the first battery information (K) and the conversion factor (n) may be rounded up. Therefore, the conversion information (C) may always be greater than or equal to the value obtained by multiplying the first battery information (K) by the conversion factor (n). For example, if the first battery information (K) is 20.2 and the conversion factor (n) is 2, the conversion information (C) may be 41.

The battery information receiving device 120 may be configured to obtain, as the second battery information, a value obtained by dividing the conversion information by a conversion factor multiplied by the first battery information according to a conversion rule.

Specifically, the second battery information is a value obtained by reconverting the conversion factor. Accordingly, the battery information receiving device 120 may obtain the second battery information by dividing the conversion information by a conversion factor multiplied by the first battery information according to the conversion rule.

For example, when the conversion factor is 2, the battery information receiving device 120 may obtain the second battery information by dividing the conversion information by 2 (conversion factor).

Referring to Formula 1, the conversion information (C) may always be less than or equal to the value obtained by multiplying the first battery information (K) by the conversion factor (n). Therefore, the second battery information obtained by dividing the conversion information (C) by the conversion factor (n) may always be smaller than or equal to the first battery information (K). That is, because the battery information receiving device 120 terminates charging of the battery based on the second battery information, it is possible to prevent the available capacity of the battery from being lost due to insufficient charge of the battery.

Referring to Formula 2, the conversion information (C) may always be greater than or equal to the first battery information (K) multiplied by the conversion factor (n). Therefore, the second battery information obtained by dividing the conversion information (C) by the conversion factor (n) may always be greater than or equal to the first battery information (K). That is, because the battery information receiving device 120 terminates discharging of the battery based on the second battery information, it is possible to prevent the available capacity of the battery from being lost due to insufficient discharge of the battery.

Meanwhile, the battery information transmission device 110 may be configured to set the conversion information to a preset discharge end value when the first battery information is less than a preset threshold value based on the second conversion rule.

Specifically, according to the second conversion rule, the second battery information may always be greater than or equal to the first battery information. Also, the discharging of the battery may be terminated according to the comparison result between the battery information and the discharging termination condition, and the battery information considered here is the second battery information. In other words, even in a state where the actual state of the battery (corresponding to the first battery information) has already satisfied the discharge end condition, battery discharge may proceed until the second battery information satisfies the discharge end condition. In this case, the battery may be overdischarged, and when the battery is overdischarged, a lithium plating phenomenon, in which lithium metal is precipitated on the negative electrode surface of the battery, may occur. Accordingly, the battery information transmission device 110 may set the conversion information to a preset discharge end value when the first battery information is less than the threshold value. The conversion information set as a discharge end value may be configured to satisfy the discharge end condition even if it is reconverted. Accordingly, the battery information receiving device 120, which has received the conversion information set to the discharge end value, may end discharging the battery immediately after obtaining the second battery information.

For example, the threshold value may be set to 0.1% and the discharge end value may be set to 0%. That is, if the first battery information is less than 0.1, the battery information transmission device 110 may set the conversion information to 0. In other words, even if the conversion information set to 0 is reconverted, the second battery information may be obtained as 0. Accordingly, the battery information receiving device 120 may prevent the battery from being overdischarged by immediately terminating the discharging of the battery.

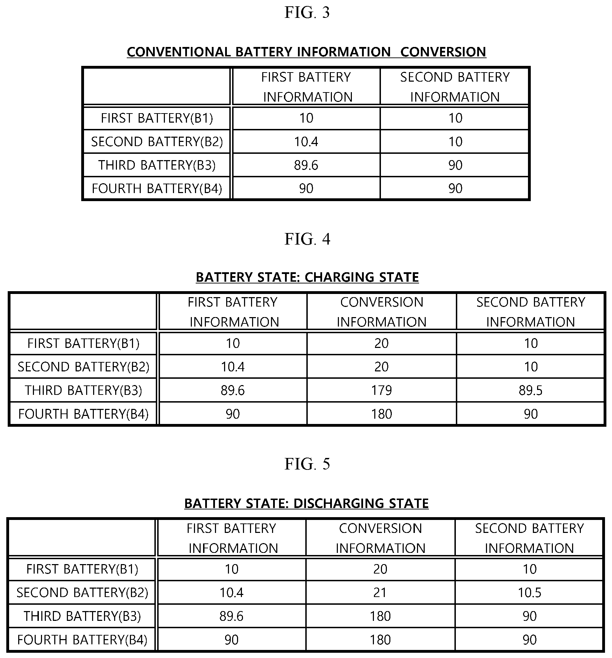

FIG. 3 is a diagram showing a comparative example of the conventional battery information conversion process. FIGS. 4 and 5 are diagrams showing an embodiment of a battery information conversion process according to an embodiment of the present disclosure.

Specifically, FIG. 3 shows a comparative example of obtaining the second battery information by rounding up below the decimal point of the first battery information in a conventional manner. FIG. 4 shows a first embodiment showing the first battery information, the conversion information, and the second battery information when the battery is in a charging state. FIG. 5 shows a second embodiment showing the first battery information, the conversion information, and the second battery information when the battery is in a discharging state.

For convenience of explanation, it is assumed that the first battery information of the first battery B1 is 10, the first battery information of the second battery B2 is 10.4, the first battery information of the third battery B3 is 89.6, and the first battery information of the fourth battery B4 is 90. Additionally, it is assumed that the charge end SOC is 90 and the discharge end SOC is 10.

Referring to FIG. 3, when the second battery information is obtained by simply rounding up below the decimal point of the first battery information, the second battery information may be obtained as 10 even though the first battery information of the second battery B2 is 10.4. In other words, the discharging of the second battery B2 may be terminated based on the second battery information even though the actual SOC of the battery has not reached the discharge end SOC (10%). That is, in the comparative example of FIG. 3, the available capacity of the second battery B2 may be lost by SOC 0.4% due to insufficient discharge. Additionally, even though the first battery information of the third battery B3 is 89.6, the second battery information may be obtained as 90. In other words, the charging of the third battery B3 may be terminated based on the second battery information even though the actual SOC of the battery has not reached the charging termination SOC (90%). That is, in the comparative example of FIG. 3, the available capacity of the third battery B3 may be lost by SOC 0.4% due to insufficient charging. That is, with the conventional method, there is a problem that available capacity may be lost in the charging state and the discharging state.

Referring to FIG. 4, when the state of the battery is the charging state, the second battery information of the third battery B3 may be obtained as 89.5. Referring to the second battery information of the fourth battery B4, the first battery information must be 90 to obtain the second battery information as 90. In other words, charging of the battery may continue until the actual SOC of the battery reaches the charge end charge SOC (90%). Therefore, loss of available capacity of the battery due to insufficient charging may be prevented.

Referring to FIG. 5, when the state of the battery is the discharging state, the second battery information of the second battery B2 may be obtained as 10.5. Referring to the second battery information of the first battery B1, the first battery information must be 10 to obtain the second battery information as 10. In other words, discharging of the battery may continue until the actual SOC of the battery reaches the discharge end SOC (10%). Therefore, loss of available capacity of the battery due to insufficient discharge may be prevented.

In other words, the battery information communication system 100 according to an embodiment of the present disclosure has the advantage of effectively preventing the loss of available capacity of the battery due to inevitable data conversion in the communication process.

The battery information transmission device 110 and the battery information receiving device 120 may be applied to a battery management system (BMS). That is, the BMS according to the present disclosure may include the battery information transmission device 110 and the battery information receiving device 120 described above. In this configuration, at least some of components of the battery information transmission device 110 and the battery information receiving device 120 may be implemented by supplementing or adding functions of the components included in a conventional BMS.

For example, the battery information transmitting device 110 may be a lower BMS, and the battery information receiving device 120 may be a higher BMS. The lower BMS may convert the battery information into the conversion information and transmit the conversion information to the higher BMS. Also, the higher BMS may obtain information about the battery by reconverting the conversion information to the second battery information. Also, the higher BMS may control battery charging and discharging based on the second battery information.

In a specific example, it is assumed that the battery information communication system 100 according to an embodiment of the present disclosure is applied to an ESS (Energy storage system). Generally, the ESS has a hierarchical structure that includes an MBMS (Module battery management system) that monitors the battery module, a RBMS (Rack battery management system) that monitors the battery rack, a BBMS (Bank battery management system) that monitors the battery bank, and a BSC (Battery system controller) that monitors the ESS. Here, the battery information may be transmitted from the MBMS to the RBMS, from the RBMS to the BBMS, and from the BBMS to the BSC.

For example, if the battery information transmitting device 110 corresponds to the RBMS, the battery information receiving device 120 may correspond to the BBMS. The BBMS may receive the conversion information from the RBMS and obtain the second battery information from the received conversion information. Additionally, the BBMS may control the charging and discharging of the battery module (a battery module included in the battery rack monitored by the RBMS) based on the second battery information.

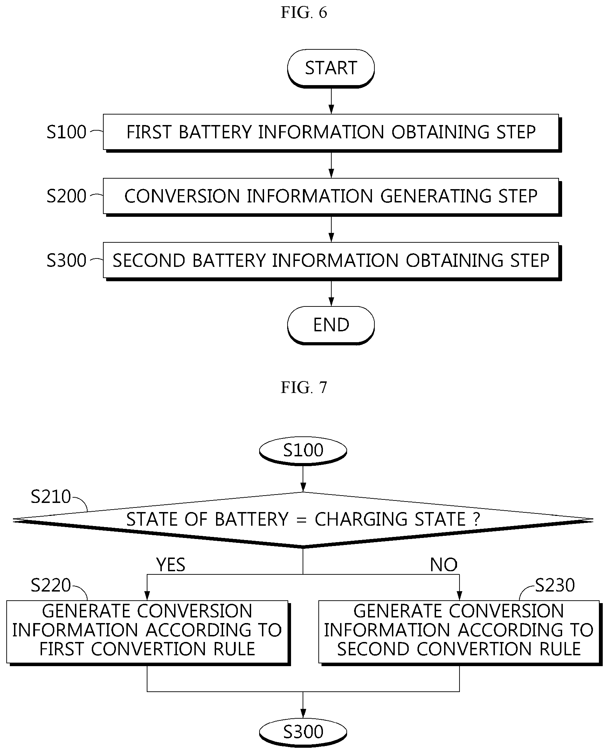

FIG. 6 is a diagram schematically showing a battery information conversion method according to another embodiment of the present disclosure.

Preferably, each step of the battery information conversion method may be performed by the battery information conversion system. Hereinafter, for convenience of explanation, content that overlaps with the content described above will be omitted or briefly described.

Referring to FIG. 6, the battery information conversion method may include a first battery information obtaining step (S100), a conversion information generating step (S200), and a second battery information obtaining step (S300).

The first battery information obtaining step (S100) is a step performed by the battery information transmission device 110, and the battery information transmission device 110 may obtain first battery information related to a battery.

For example, the battery information transmission device 110 may directly measure and/or estimate first battery information or receive predetermined first battery information from the outside.

The conversion information generating step (S200) is a step performed by the battery information transmission device 110. The battery information transmission device 110 may generate conversion information by applying a preset conversion rule to the first battery information to correspond to the charging and discharging state of the battery.

FIG. 7 is a diagram more specifically showing the conversion information generation step (S200) in the battery information conversion method according to another embodiment of the present disclosure.

In step S210, the battery information transmission device 110 may determine whether the state of the battery is a charging state. Here, it is determined whether the state of the battery is a charging state, but note that depending on the embodiment, it may be determined whether the state of the battery is a discharging state.

If the determination result of step S210 is 'YES', step S220 may be performed, and if it is 'NO', step S230 may be performed.

In step S220, the battery information transmission device 110 may convert the first battery information into conversion information according to a first conversion rule. That is, when the state of the battery is the charging state, the conversion information may be generated according to the first conversion rule.

In step S230, the battery information transmission device 110 may convert the first battery information into conversion information according to a second conversion rule. That is, when the state of the battery is the discharging state, the conversion information may be generated according to the second conversion rule.

The second battery information obtaining step (S300) is a step performed by the battery information receiving device 120. The battery information receiving device 120 may reconvert the conversion information to correspond to the conversion rule to obtain second battery information corresponding to the first battery information.

For example, when the state of the battery is the charging state, the battery information receiving device 120 may obtain second battery information having a value less than or equal to the first battery information.

Conversely, when the state of the battery is the discharging state, the battery information receiving device 120 may obtain second battery information having a value greater than or equal to the first battery information.

Accordingly, since the battery information receiving device 120 controls charging and discharging of the battery based on the second battery information, loss of available capacity of the battery due to insufficient charging and discharging may be prevented.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

100: battery information communication system
110: battery information transmission device
120: battery information receiving device

## Claims

1. A battery information communication system (100), comprising:
a battery information transmission device (110) configured to obtain first battery information related to a battery, generate conversion information by applying a preset conversion rule to the first battery information to correspond to a charging and discharging state of the battery, and transmit the conversion information; and
a battery information receiving device (120) configured to receive the conversion information from the battery information transmission device, and reconvert the conversion information to correspond to the conversion rule to obtain second battery information corresponding to the first battery information;
wherein the battery information transmission device is configured to:
generate the conversion information by applying a preset first conversion rule when the battery is in a charging state, and
generate the conversion information by applying a preset second conversion rule when the battery is in a discharging state.

2. The battery information communication system according to claim 1,
wherein the battery information transmission device is configured to generate the conversion information by converting a weight value of the battery information by rounding down below a decimal point, based on the first conversion rule.

3. The battery information communication system according to claim 2,
wherein the battery information transmission device is configured to generate the conversion information according to the first conversion rule based on Formula 1 below, [Formula 1] $C = \left⌊K\times n\right⌋$
where C is the conversion information, K is the first battery information, and n is a predetermined conversion factor.

4. The battery information communication system according to claim 1,
wherein the battery information transmission device is configured to generate the conversion information by converting a weight value of the battery information by rounding up below a decimal point, based on the second conversion rule.

5. The battery information communication system according to claim 4,
wherein the battery information transmission device is configured to generate the conversion information according to the second conversion rule based on Formula 2 below, [Formula 2] $C = \left⌈K\times n\right⌉$
where C is the conversion information, K is the first battery information, and n is a predetermined conversion factor.

6. The battery information communication system according to claim 4,
wherein the battery information transmission device is configured to set the conversion information to a preset discharge end value when the first battery information is less than a preset threshold value, based on the second conversion rule.

7. The battery information communication system according to claim 1,
wherein the battery information receiving device is configured to:
obtain the second battery information with a value less than or equal to the first battery information when the battery is in a charging state, and
obtain the second battery information with a value greater than or equal to the first battery information when the battery is in a discharging state.

8. The battery information communication system according to claim 7,
wherein the battery information receiving device is configured to obtain, as the second battery information, a value obtained by dividing the conversion information by a conversion factor multiplied by the first battery information according to the conversion rule.

9. The battery information communication system according to claim 1,
wherein the battery information receiving device is configured to control charging and discharging of the battery based on the second battery information.

10. An ESS (Energy storage system), comprising the battery information communication system according to any one of claims 1 to 9.

11. A battery information communication method, comprising:
a first battery information obtaining step (S100) of obtaining first battery information related to a battery by a battery information transmission device (110);
a conversion information generating step (S200) of generating conversion information by applying a preset conversion rule to the first battery information to correspond to a charging and discharging state of the battery by the battery information transmission device; and
a second battery information obtaining step (S300) of reconverting the conversion information to correspond to the conversion rule to obtain second battery information corresponding to the first battery information by a battery information receiving device (120);
wherein generating the conversion information is performed:
by applying a preset first conversion rule when the battery is in a charging state, and
by applying a preset second conversion rule when the battery is in a discharging state

## Patentansprüche

1. Batterieinformations-Kommunikationssystem (100), umfassend:
• eine Batterieinformations-Übertragungsvorrichtung (110), die dazu eingerichtet ist, erste Batterieinformationen in Bezug auf eine Batterie zu erhalten, Konvertierungsinformationen durch Anwenden einer vorgegebenen Konvertierungsregel auf die ersten Batterieinformationen zu erzeugen, um einem Lade- und Entladezustand der Batterie zu entsprechen, und die Konvertierungsinformationen zu übertragen; und
• eine Batterieinformations-Empfangsvorrichtung (120), die dazu eingerichtet ist, die Konvertierungsinformationen von der Batterieinformations-Übertragungsvorrichtung zu empfangen und die Konvertierungsinformationen so zu rekonvertieren, dass sie der Konvertierungsregel entsprechen, um zweite Batterieinformationen zu erhalten, die den ersten Batterieinformationen entsprechen;
• wobei die Batterieinformations-Übertragungsvorrichtung eingerichtet ist zum:
• Erzeugen der Konvertierungsinformationen durch Anwenden einer vorgegebenen ersten Konvertierungsregel, wenn sich die Batterie in einem Ladezustand befindet, und
• Erzeugen der Konvertierungsinformationen durch Anwenden einer vorgegebenen zweiten Konvertierungsregel, wenn sich die Batterie in einem Entladezustand befindet.

2. Batterieinformations-Kommunikationssystem nach Anspruch 1,
wobei die Batterieinformations-Übertragungsvorrichtung dazu eingerichtet ist, die Konvertierungsinformationen durch Konvertieren eines Gewichtungswerts der Batterieinformationen durch Abrunden unter eine Dezimalstelle basierend auf der ersten Konvertierungsregel zu erzeugen.

3. Batterieinformations-Kommunikationssystem nach Anspruch 2,
wobei die Batterieinformations-Übertragungsvorrichtung dazu eingerichtet ist, die Konvertierungsinformationen gemäß der ersten Konvertierungsregel basierend auf der nachstehenden Formel 1 zu erzeugen, [Formel 1] $C = \left[K\times n\right]$
wobei C die Konvertierungsinformationen ist, K die ersten Batterieinformationen ist und n ein vorgegebener Konvertierungsfaktor ist.

4. Batterieinformations-Kommunikationssystem nach Anspruch 1,
wobei die Batterieinformations-Übertragungsvorrichtung dazu eingerichtet ist, die Konvertierungsinformationen durch Konvertieren eines Gewichtungswerts der Batterieinformationen durch Aufrunden unter eine Dezimalstelle basierend auf der zweiten Konvertierungsregel zu erzeugen.

5. Batterieinformations-Kommunikationssystem nach Anspruch 4,
wobei die Batterieinformations-Übertragungsvorrichtung dazu eingerichtet ist, die Konvertierungsinformationen gemäß der zweiten Konvertierungsregel basierend auf der nachstehenden Formel 2 zu erzeugen, [Formel 2] $C = \left[K\times n\right]$
wobei C die Konvertierungsinformationen ist, K die ersten Batterieinformationen ist und n ein vorgegebener Konvertierungsfaktor ist.

6. Batterieinformations-Kommunikationssystem nach Anspruch 4,
wobei die Batterieinformations-Übertragungsvorrichtung dazu eingerichtet ist, die Konvertierungsinformationen basierend auf der zweiten Konvertierungsregel auf einen vorgegebenen Entladeendwert einzustellen, wenn die ersten Batterieinformationen kleiner als ein vorgegebener Schwellenwert sind.

7. Batterieinformations-Kommunikationssystem nach Anspruch 1,
wobei die Batterieinformations-Empfangsvorrichtung eingerichtet ist zum:
• Erhalten der zweiten Batterieinformationen mit einem Wert kleiner oder gleich den ersten Batterieinformationen, wenn sich die Batterie in einem Ladezustand befindet, und
• Erhalten der zweiten Batterieinformationen mit einem Wert größer oder gleich den ersten Batterieinformationen, wenn sich die Batterie in einem Entladezustand befindet.

8. Batterieinformations-Kommunikationssystem nach Anspruch 7,
wobei die Batterieinformations-Empfangsvorrichtung dazu eingerichtet ist, als die zweiten Batterieinformationen einen Wert zu erhalten, der durch Teilen der Konvertierungsinformationen durch einen mit den ersten Batterieinformationen multiplizierten Konvertierungsfaktor gemäß der Konvertierungsregel erhalten wird.

9. Batterieinformations-Kommunikationssystem nach Anspruch 1,
wobei die Batterieinformations-Empfangsvorrichtung dazu eingerichtet ist, das Laden und Entladen der Batterie basierend auf den zweiten Batterieinformationen zu steuern.

10. ESS (Energiespeichersystem), umfassend das Batterieinformations-Kommunikationssystem nach einem der Ansprüche 1 bis 9.

11. Batterieinformations-Kommunikationsverfahren, umfassend:
• einen Schritt des Erhaltens erster Batterieinformationen (S100) des Erhaltens erster Batterieinformationen in Bezug auf eine Batterie durch eine Batterieinformations-Übertragungsvorrichtung (110);
• einen Schritt des Erzeugens von Konvertierungsinformationen (S200) des Erzeugens von Konvertierungsinformationen durch Anwenden einer vorgegebenen Konvertierungsregel auf die ersten Batterieinformationen, um einem Lade- und Entladezustand der Batterie zu entsprechen, durch die Batterieinformations-Übertragungsvorrichtung; und
• einen Schritt des Erhaltens zweiter Batterieinformationen (S300) des Rekonvertierens der Konvertierungsinformationen, so dass sie der Konvertierungsregel entsprechen, um zweite Batterieinformationen zu erhalten, die den ersten Batterieinformationen entsprechen, durch eine Batterieinformations-Empfangsvorrichtung (120);
• wobei das Erzeugen der Konvertierungsinformationen durchgeführt wird:
• durch Anwenden einer vorgegebenen ersten Konvertierungsregel, wenn sich die Batterie in einem Ladezustand befindet, und
• durch Anwenden einer vorgegebenen zweiten Konvertierungsregel, wenn sich die Batterie in einem Entladezustand befindet.

## Revendications

1. Système de communication d'informations de batterie (100), comprenant :
• un dispositif de transmission d'informations de batterie (110) configuré pour obtenir des premières informations de batterie relatives à une batterie, générer des informations de conversion en appliquant une règle de conversion prédéfinie aux premières informations de batterie pour correspondre à un état de charge et de décharge de la batterie, et transmettre les informations de conversion ; et
• un dispositif de réception d'informations de batterie (120) configuré pour recevoir les informations de conversion en provenance du dispositif de transmission d'informations de batterie, et reconvertir les informations de conversion pour correspondre à la règle de conversion afin d'obtenir des deuxièmes informations de batterie correspondant aux premières informations de batterie ;
• dans lequel le dispositif de transmission d'informations de batterie est configuré pour :
• générer les informations de conversion en appliquant une première règle de conversion prédéfinie lorsque la batterie est dans un état de charge, et
• générer les informations de conversion en appliquant une deuxième règle de conversion prédéfinie lorsque la batterie est dans un état de décharge.

2. Système de communication d'informations de batterie selon la revendication 1,
dans lequel le dispositif de transmission d'informations de batterie est configuré pour générer les informations de conversion en convertissant une valeur de pondération des informations de batterie par arrondi par défaut sous la virgule décimale, sur la base de la première règle de conversion.

3. Système de communication d'informations de batterie selon la revendication 2,
dans lequel le dispositif de transmission d'informations de batterie est configuré pour générer les informations de conversion selon la première règle de conversion sur la base de la formule 1 ci-dessous, [Formule 1] $C = \left[K\times n\right]$
où C représente les informations de conversion, K représente les premières informations de batterie et n est un facteur de conversion prédéterminé.

4. Système de communication d'informations de batterie selon la revendication 1,
dans lequel le dispositif de transmission d'informations de batterie est configuré pour générer les informations de conversion en convertissant une valeur de pondération des informations de batterie par arrondi par excès sous la virgule décimale, sur la base de la deuxième règle de conversion.

5. Système de communication d'informations de batterie selon la revendication 4,
dans lequel le dispositif de transmission d'informations de batterie est configuré pour générer les informations de conversion selon la deuxième règle de conversion sur la base de la formule 2 ci-dessous, [Formule 2] $C = \left[K\times n\right]$
où C représente les informations de conversion, K représente les premières informations de batterie et n est un facteur de conversion prédéterminé.

6. Système de communication d'informations de batterie selon la revendication 4,
dans lequel le dispositif de transmission d'informations de batterie est configuré pour régler les informations de conversion sur une valeur de fin de décharge prédéfinie lorsque les premières informations de batterie sont inférieures à une valeur de seuil prédéfinie, sur la base de la deuxième règle de conversion.

7. Système de communication d'informations de batterie selon la revendication 1, dans lequel le dispositif de réception d'informations de batterie est configuré pour :
• obtenir les deuxièmes informations de batterie avec une valeur inférieure ou égale aux premières informations de batterie lorsque la batterie est dans un état de charge, et
• obtenir les deuxièmes informations de batterie avec une valeur supérieure ou égale aux premières informations de batterie lorsque la batterie est dans un état de décharge.

8. Système de communication d'informations de batterie selon la revendication 7,
dans lequel le dispositif de réception d'informations de batterie est configuré pour obtenir, en tant que deuxièmes informations de batterie, une valeur obtenue en divisant les informations de conversion par un facteur de conversion multiplié par les premières informations de batterie selon la règle de conversion.

9. Système de communication d'informations de batterie selon la revendication 1,
dans lequel le dispositif de réception d'informations de batterie est configuré pour commander la charge et la décharge de la batterie sur la base des deuxièmes informations de batterie.

10. SSE (Système de Stockage d'Energie), comprenant le système de communication d'informations de batterie selon l'une quelconque des revendications 1 à 9.

11. Procédé de communication d'informations de batterie, comprenant :
• une étape d'obtention de premières informations de batterie (S100) consistant à obtenir des premières informations de batterie relatives à une batterie par un dispositif de transmission d'informations de batterie (110) ;
• une étape de génération d'informations de conversion (S200) consistant à générer des informations de conversion en appliquant une règle de conversion prédéfinie aux premières informations de batterie pour correspondre à un état de charge et de décharge de la batterie par le dispositif de transmission d'informations de batterie ; et
• une étape d'obtention de deuxièmes informations de batterie (S300) consistant à reconvertir les informations de conversion pour correspondre à la règle de conversion afin d'obtenir des deuxièmes informations de batterie correspondant aux premières informations de batterie par un dispositif de réception d'informations de batterie (120) ;
• dans lequel la génération des informations de conversion est effectuée :
• en appliquant une première règle de conversion prédéfinie lorsque la batterie est dans un état de charge, et
• en appliquant une deuxième règle de conversion prédéfinie lorsque la batterie est dans un état de décharge.
